# EUROPÄISCHE PATENTSCHRIFT

(11) **EP 4 255 774 B1**
(45) Veröffentlichungstag und Bekanntmachung des Hinweises auf die Patenterteilung: **12.06.2024**
(21) Anmeldenummer: 21830418.6
(22) Anmeldetag: 03.12.2021
(51) Int. Cl.: B60Q 1/14, B60Q 1/42

(54) **LENKSTOCKSCHALTER FÜR EIN KRAFTFAHRZEUG**
STEERING COLUMN SWITCH FOR A MOTOR VEHICLE
COMMUTATEUR DE COLONNE DE DIRECTION POUR VÉHICULE AUTOMOBILE

(30) Priorität: 07.12.2020 DE 102020007438
(43) Veröffentlichungstag der Anmeldung: 11.10.2023
(73) Patentinhaber: KOSTAL Automobil Elektrik GmbH & Co. KG, 58513 Lüdenscheid (DE)
(72) Erfinder: TRINN, Alexander, 58515 Lüdenscheid (DE)
(74) Vertreter: Kerkmann, Detlef
(86) Internationale Anmeldenummer: PCT/EP2021/084231
(87) Internationale Veröffentlichungsnummer: WO 2022/122592

(56) Entgegenhaltungen:
- CN-A- 107 452 540
- DE-U1- 29 901 614
- JP-A- 2016 012 465
- US-A1- 2003 001 705
- US-A1- 2009 139 850
- US-A1- 2017 140 886

## Beschreibung

Die Erfindung betrifft einen Lenkstockschalter für ein Kraftfahrzeug, mit einem in zwei zueinander senkrechten Richtungen verschwenkbaren Schalthebel, mit einem um eine erste Achse verschwenkbar gelagerten Schaltstück, wobei der Schalthebel in dem Schaltstück um eine zur ersten Achse senkrecht angeordnete zweiten Achse verschwenkbar gelagert ist, wobei der Schalthebel an einem Endstück eine federbelastete Rasthülse trägt, die in einer Rastkurve an verschiedenen Positionen einrastbar ist, und mit mindestens einem Magneten und mindestens einem Magnetsensor, die durch Bewegungen des Schalthebels relativ zueinander positionierbar sind.

Zur Erkennung der eingestellten Position des Schalthebels ist somit ein magnetisches Schaltsystem vorgesehen. Bei einem Lenkstockschalter mit einem solchen Schaltsystem ist üblicherweise ein als Dauermagnet ausgeführter Magnet entweder am Schalthebel angeordnet oder mit dem Schalthebel verbunden, so dass der Magnet direkt den Schwenkbewegungen des Schalthebels folgt.

Ein derartiger Lenkstockschalter ist aus der deutschen Offenlegungsschrift DE 10 2011 111 871 A1 bekannt. Die in diesem Dokument beschriebene Vorrichtung sieht einen Betätigungshebel mit einem daran angeordneten Magneten vor, wobei an einer Kulisse, die eine Vielzahl von möglichen Raststellungen für den Betätigungshebel aufweist, an jeder Raststellung ein Magnetsensor angeordnet ist.

Ein solcher Aufbau ist schon allein wegen der Vielzahl von erforderlichen Magnetsensoren relativ aufwendig. Bei diesem Lenkstockschalter sind die Magnetsensoren zudem hinter der Rastkurve angeordnet, was sich ungünstig auf die Baulänge des Lenkstockschalters auswirkt.

Außer einem Rastsystem zur Erzeugung einer Betätigungshaptik und einem Schaltsystem zur Ermittlung der eingestellten Schaltstellung des Schalthebels, hier ausgeführt durch eine Magnetsensorik, weisen viele Lenkstockschalter noch ein Auslösesystem auf, welches eine automatische Rückstellung des Schalthebels aus den Schaltstellungen ermöglicht, in denen der Lenkstockschalter als Blinkgeberschalter fungiert.

Einem Lenkstockschalter in einem Kraftfahrzeug steht üblicherweise nur ein begrenzter Bauraum zur Verfügung. Die vorgenannten Systeme müssen daher aufeinander abgestimmt sein, damit sie alle in dem zur Verfügung stehenden Bauraum untergebracht werden können.

Da sowohl das Auslösesystem, als auch das Rastsystem hinsichtlich ihrer Position und ihrer Anordnung nicht viele Freiheitsgrade besitzen, muss das magnetische Schaltsystem meist einen Platz seitlich neben diesen beiden finden. Die Suche nach einer geeigneten Position ist oft ein Kompromiss zwischen Bauraumbedarf und Systemrobustheit.

Die Offenlegungsschrift US 2009/139850A1 zeigt einen Lenkstockschalter gemäß dem Oberbegriff des Patentanspruchs 1. An dem Schaltstück dieses Lenkstockschalters ist ein mit einem Magneten verbundener Schlitten so gelagert, dass dieser senkrecht zu einer ersten Achse linear verschiebbar ist und der den Bewegungen des Schalthebels um eine zweite Achse folgt. Bei Schwenkbewegungen des Schalthebels um dessen erste Achse wird der Magnet mitverschwenkt.

Es stellte sich daher die Aufgabe, einen derartigen Lenkstockschalter mit einem besonders kompakten und die anderen Komponenten möglichst wenig beeinflussenden Schaltsystem zu schaffen.

Diese Aufgabe wird erfindungsgemäß dadurch gelöst, dass der mindestens eine Magnet fest mit einem Schlitten verbunden ist, der parallel zur ersten Achse linear verschiebbar am Schaltstück gelagert ist und der den Bewegungen des Schalthebels um die zweite Achse folgt, und dass der mindestens eine Magnet bei Schwenkbewegungen des Schaltstücks um dessen erste Achse mit verschwenkt wird.

Das hier vorgeschlagene Schaltsystem ist somit in einer Richtung linear geführt. Dagegen arbeiten viele bekannte Schaltsysteme sowohl in der horizontalen als auch der vertikalen Schaltrichtung des Schalthebels rotatorisch.

Das vorgeschlagene Schaltsystem kann aufgrund seines Aufbaus so angeordnet werden, daß es die anderen Systeme wenig bis gar nicht beeinflusst und selbst ebenfalls nicht durch anderen Systeme eingeschränkt wird.

Diesbezüglich besonders vorteilhaft ist es, wenn der Schlitten rahmenartig ausgebildet ist und eine Ausnehmung aufweist, durch die die Rasthülse hindurchgeführt ist.

Ebenfalls sehr vorteilhaft kann auch mindestens ein Teil eines Auslösesystems, welches zum Zurückführen des Schalthebels aus einer betätigten Schaltstellung geeignet ist, durch die Ausnehmung hindurchgeführt sein.

Das magnetische Schaltsystem kann um das Auslösesystem "herumgreifen", und mit seiner Sensorik unterhalb des Rastsystems angeordnet sein. Durch diese Anordnung kann das Schaltsystem weitgehend unbeeinflusst von den andern Systemen hinsichtlich der Robustheit optimiert werden.

Des Weiteren bringen der Aufbau und die Ansteuerung des erfindungsgemäßen Schaltsystems den Vorteil von zusätzlichen Freiheitsgraden bei der Positionierung des Schaltsystems mit sich: während bekannte Systeme nur eine eingeschränkte Ausrichtung erlauben, ohne sich teils erhebliche Nachteile bei der Auswertung einzukaufen, kann die Sensorik des erfindungsgemäßen Schaltsystems frei um die erste Schwenkachse des Schaltstücks herum gedreht angeordnet werden, ohne daß sich die Qualität der Auswertung verschlechtert.

Besonders vorteilhaft ist es, vorzusehen, dass der Schlitten mittels eines am Schaltstück drehbar gelagerten Umlenkhebels mit dem Schalthebel gekoppelt ist. Hierdurch wird erreicht, dass der Umlenkhebel Bewegungen des Schalthebels um die zweite Achse mit einer Hebelübersetzung auf den Schlitten überträgt.

Nachfolgend soll die Erfindung anhand der Zeichnung dargestellt und erläutert werden. Die Figuren 1 bis 3 zeigen jeweils ein erstes Ausführungsbeispiel eines erfindungsgemäßen Lenkstockschalters ohne ein umgebendes Gehäuse, und zwar in der
- Figur 1: in einer Draufsicht, in der
- Figur 2: in eine Explosionsansicht, und in der
- Figur 3: in einer Schnittansicht.

Die Figuren 4 bis 6 zeigen jeweils ein zweites Ausführungsbeispiel eines erfindungsgemäßen Lenkstockschalters ohne ein umgebendes Gehäuse, und zwar in der

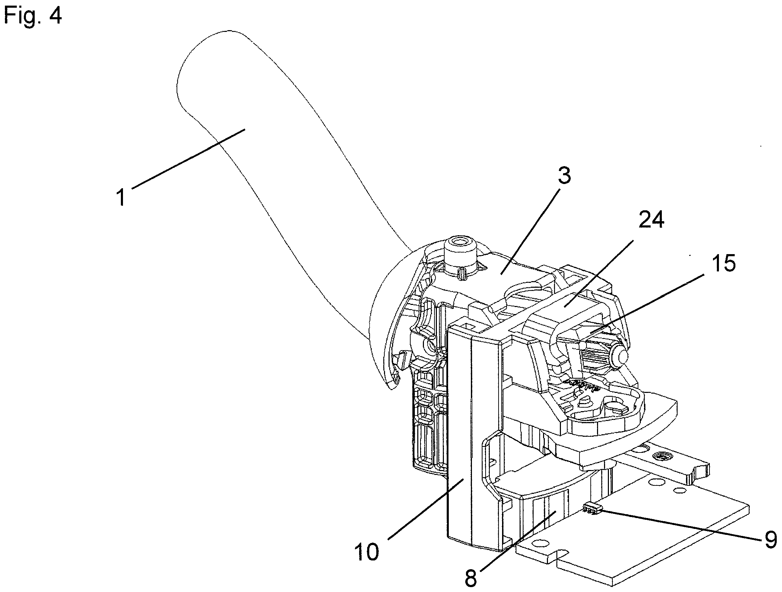

- Figur 4: in einer Draufsicht, in der

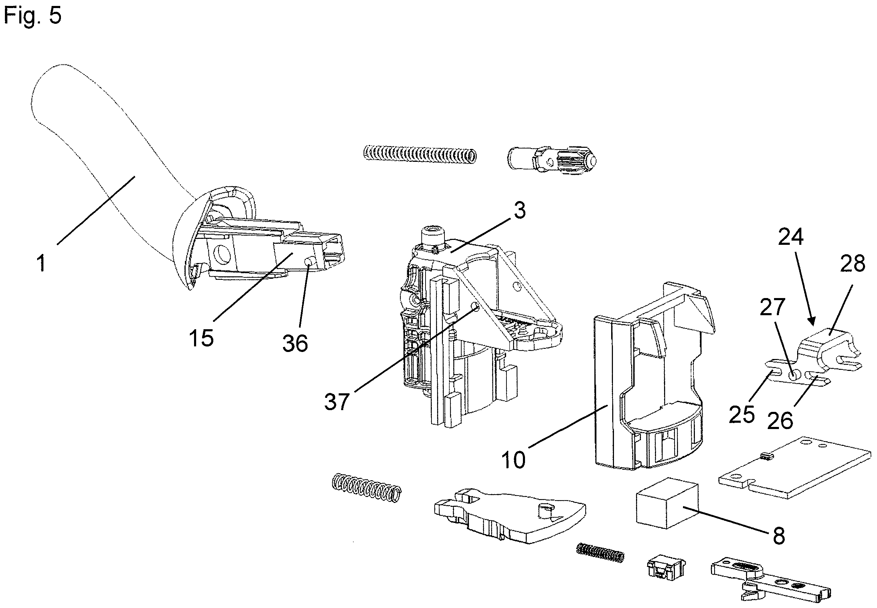

- Figur 5: in eine Explosionsansicht, und in der

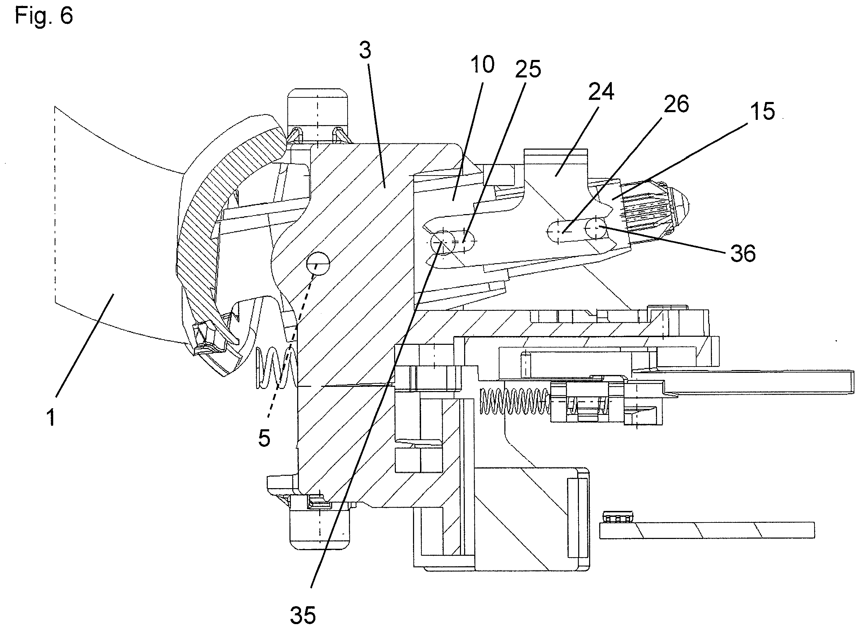

- Figur 6: in einer Schnittansicht.

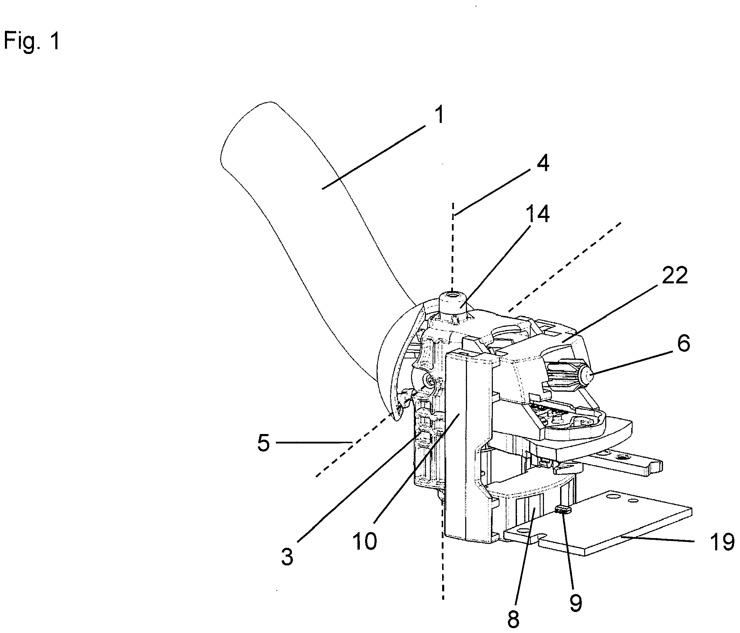

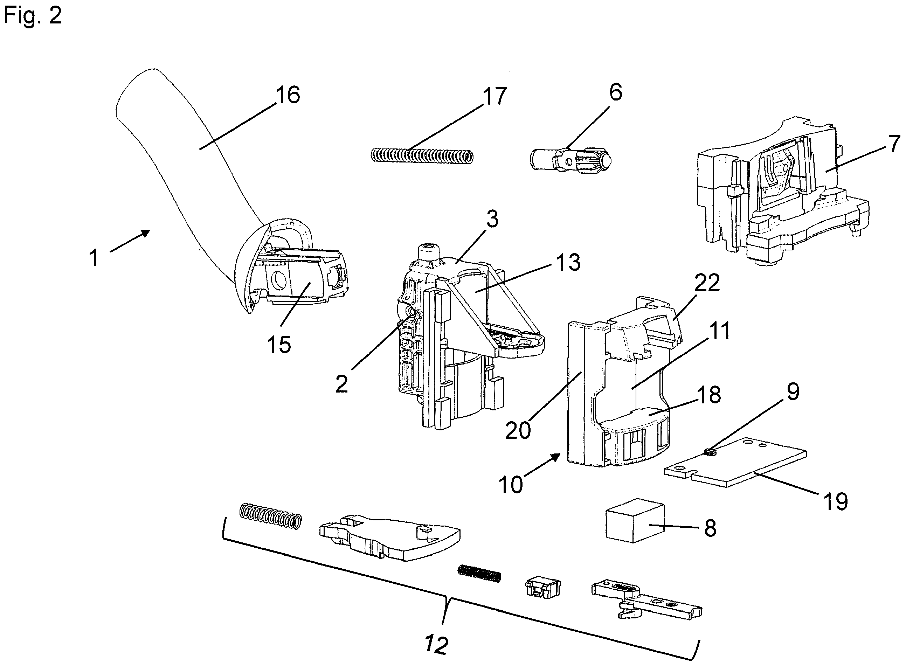

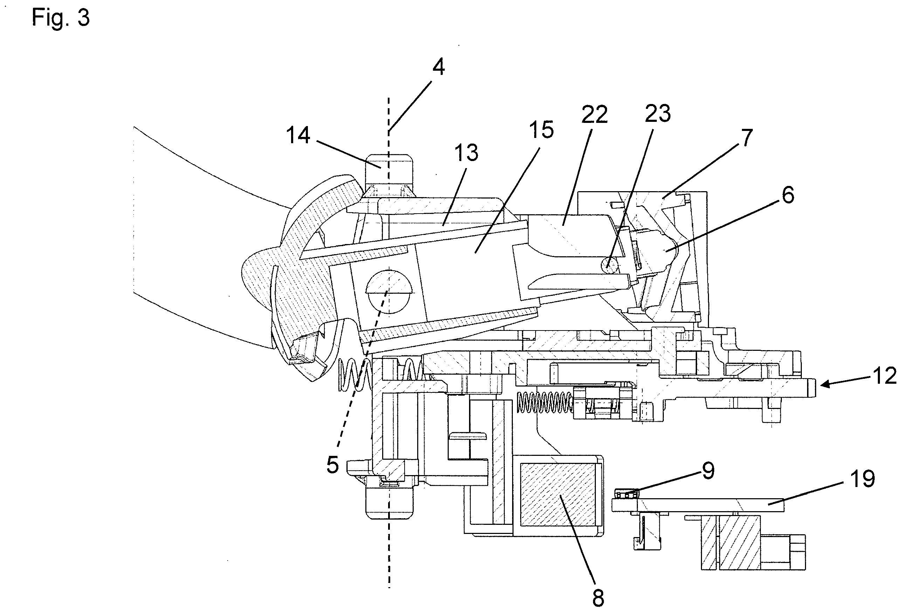

Die Figur 1 zeigt den Lenkstockschalter zusätzlich ohne eine Rastkurve 7, welche aber in den Figuren 2 und 3 dargestellt ist. Die nachfolgende Beschreibung bezieht sich auf alle Figuren gemeinsam.

Der Lenkstockschalter weist ein Schaltstück 3 auf, an dem an zwei einander gegenüberliegenden Außenflächen Achsstummel als Lagerstellen 14 angeformt sind. Im vollständig montierten Zustand sind die Achsstummel als Lagerstellen 14 in Ausnehmungen eines hier nicht dargestellten Gehäuses eingesetzt, wodurch das Schaltstück 3 um eine erste Achse 4 verschwenkbar gelagert ist. Das Gehäuse kann insbesondere an der Lenksäule eines Kraftfahrzeugs angeordnet sein oder sogar als Bestandteil der Lenksäule ausgeführt sein.

Das Schaltstück 3 weist einen Durchbruch 13 auf, seitlich zu dem sich zwei Lagerstellen 2 befinden, an denen der Schalthebel 1 um eine zweite Achse 5 verschwenkbar gelagert ist. Dabei durchragt ein Endstück 15 des Schalthebels 1 den Durchbruch 13 des Schaltstücks 3.

Unterhalb des Durchbruchs 13 ist am Schaltstück 3 eine aus mehreren Komponenten bestehende Vorrichtung angeordnet, deren Funktion es ist, den Schalthebel 1 aus einer ausgelenkten Position in eine Grundstellung zurückzuführen, und die hier zusammenfassend als Auslösesystem 12 bezeichnet werden sollen. Die Funktionsweise des Auslösesystems 12 soll hier nicht im Detail beschrieben werden, da grundsätzlich bekannt ist und sie zum Verständnis der Erfindung nicht wesentlich ist. Die prinzipielle Funktionsweise eines Auslösesystem wird beispielsweise in der deutschen Gebrauchsmusterschrift DE 81 12 331 U1 erläutert.

Das Endstück 15 ist fest mit einem Griffstück 16 des Schalthebels 1 verbunden, das zur manuellen Betätigung des Schalthebels 1 vorgesehen ist und durch dessen Bewegungen in verschiedenen Richtungen erstens das Schaltstück 3 um die erste Achse 4 und zweitens auch der Schalthebel 1 innerhalb des Schaltstücks 3 um die zweite Achse 5 verschwenkt werden kann. Dabei sind die Lagerstellen 2 für den Schalthebel 1 so zu den Lagerstellen 14 des Schaltstücks 3 angeordnet, dass die erste und zweite Achse 4, 5 senkrecht zueinander ausgerichtet sind.

Innerhalb einer Bohrung im Endstück 15 ist eine mit einer Druckfeder 17 belastete Rasthülse 6 angeordnet, die mit ihrer Spitze an der Rastkurve 7 anliegt und dort an mehreren Positionen einrasten kann. Diese Positionen, die der Schalthebel 1 entweder stabil oder labil an der Rastkurve 7 einnehmen kann, definieren die möglichen Schaltstellungen des Schalthebels 1.

Die aktuell eingestellte Schaltstellung des Schalthebels 1 wird mittels einer Magnetsensorik ermittelt. Dazu wird die Position eines Magneten 8 relativ zu einem Magnetsensor 9 erfasst, indem die Signale des Magnetsensors 9 durch eine hier nicht darstellte Elektronik ausgewertet werden.

Erfindungsgemäß ist vorgesehen, dass der Magnet 8 fest mit einem Schlitten 10 verbunden ist, der parallel zur ersten Achse 4 linear verschiebbar am Schaltstück 3 gelagert ist und der den Bewegungen des Schalthebels 1 um die zweite Achse 5 folgt, und der bei Schwenkbewegungen des Schaltstücks 3 um die erste Achse 4 mit verschwenkt wird.

Der Schlitten 10 ist dazu rahmenartig ausgebildet und weist eine Ausnehmung 11 auf, durch die die Rasthülse 6 sowie Teile des Auslösesystems 12 hindurchgeführt sind. Durch den rahmenartigen Aufbau ist der Schlittens 10 sehr kompakt ausgebildet und benötigt nur wenig Anbauraum am Schaltstück 3.

Der Schlitten 10 weist zwei zueinander parallele Seitenteile 20 auf, welche mit am Schaltstück 3 angeformten Gleitnuten 21 zu einer Gleitführung verbunden sind. Hierzu sind an den Innenseiten der Seitenteile 20 angeformte Führungselemente in die Gleitnuten 21 eingesetzt. Die in den Figuren nicht erkennbaren Führungselemente können insbesondere in Form kurzer Stifte ausgebildet sein. Im oberen Teil des Schlittens 10 sind die Seitenteile 20 mit einem Querträger 22 verbunden, der über ein Mitnahmeelement 23 mit dem Endstück 15 des Schalthebels 1 gekoppelt ist.

Der untere Teil des Schlittens 10 wird durch einen Magnethalter 18 gebildet, der einen oder mehrere Magnete 8 trägt. Der mindestens eine Magnet 8 kann vorzugsweise in den Magnethalter 18 eingeklebt oder eingespritzt sein. Der Magnethalter 18 kann entweder einstückig mit den Seitenteilen 20 des Schlittens 10 ausgebildet sein oder, wie in den Figuren dargestellt, als ein Einzelteil gefertigt sein, das mit den Seitenteilen 20 des Schlittens 10, etwa durch Verrasten, verbunden ist.

Bewegungen des Magneten 8 werden durch einen Magnetsensor 9 erfasst, der auf einer Leiterplatte 19 angeordnet ist, die relativ zu dem hier nicht dargestellten Gehäuse fest angeordnet ist. Der Magnetsensor 9, der bevorzugt als ein dreidimensional messender Hallsensor ausgeführt sein kann, erfasst sowohl die Intensität als auch die Richtung des ihn durchdringenden Magnetfelds, und kann dadurch Linearbewegungen und Schwenkbewegungen des Schlittens 10 unterscheiden.

Bei der in den Figuren dargestellten Ausführung werden keine beweglichen Anschlussleitungen für den Magnetsensor 9 benötigt.

Die Ausrichtung des/der Magneten 8 zum Magnetsensor 9 muss keineswegs, wie in den Figuren dargestellt, in Längsrichtung des Lenkstockschalters, also etwa parallel zur Rasthülse 6 sein. Stattdessen kann auch eine um die erste Achse 4 gedrehte Anordnung des Magnethalters 18 am Schlitten 10 vorgesehen werden, wobei die Ausrichtung des Magnetsensors 9 entsprechend angepasst ist.

Eine solche gedrehte Ausrichtung des Schaltsystems hat keinen Einfluss auf die Auswertung, schafft aber eine erhöhte Flexibilität bei der Ausgestaltung des Lenkstockschalters.

Die Figuren 4 bis 6 verdeutlichen eine besonders vorteilhafte Ausführung des erfindungsgemäßen Lenkstockschalters. Der Aufbau dieses zweiten Ausführungsbeispiels stimmt mit dem des zuvor anhand der Figuren 1 bis 3 beschriebenen ersten Ausführungsbeispiels in vielen Details überein; daher kann auf eine Wiederholung der Erläuterung der bereits beschriebenen Details hier verzichtet werden. Die nachfolgende Beschreibung bezieht sich daher vor allem auf die die beiden Ausführungen unterscheidenden Merkmale. Bereits am ersten Ausführungsbeispiel eingeführte Bezugszeichen werden für gleiche und gleichwirkende Teile beibehalten.

Charakteristisch für das in den Figuren 4 bis 6 dargestellte Ausführungsbeispiel ist, dass hierbei der Schlitten 10 mittels eines am Schaltstück 3 drehbar gelagerten Umlenkhebels 24 mit dem Schalthebel 1 gekoppelt ist, wodurch der Umlenkhebel 24 Bewegungen des Schalthebels 1 um die zweite Achse 5 mit einer Hebelübersetzung auf den Schlitten 10 überträgt.

Der Umlenkhebel 24 ist als Einzelteil besonders deutlich in der Figur 5 zu erkennen. Er besteht aus einem Verbindungssteg 28, an den einander parallel gegenüberstehend jeweils erste und zweite Langlochführungen 25, 26 sowie ein dazwischen angeordneter Lagerstift 27 angeformt sind.

Die Lagerstifte 27 sind in Lagerausnehmungen 37 am Schaltstück 3 eingesetzt, wodurch der Umlenkhebel 24 am Schaltstück 3 drehbar gelagert ist. In die ersten Langlochführungen 25 greifen am Schlitten 10 angeformte erste Führungsstifte 35 ein, von denen einer in der Figur 6 erkennbar ist. Die zweiten Langlochführungen 26 des Umlenkhebels 24 wirken mit zweiten Führungsstiften 36 am Endstück 15 des Schalthebels 1 zusammen. Der Umlenkhebel 24 bildet so einen im physikalischen Sinne zweiarmigen Hebel aus.

Das Verschwenken des Schalthebels 1 um seine zweite Achse 5 bewirkt so ein Verschwenken des Umlenkhebels 24 und zugleich ein Verschieben des mit dem Umlenkhebel 24 gekoppelten Schlittens 10. Hierbei bewegt sich der Schlitten 10 umgekehrt zum Endstück 15 des Schalthebels 1 beziehungsweise genau entsprechend der Bewegungsrichtung des Griffstücks des Schalthebels 1.

Für die Funktionsweise des gesamten Schaltsystems ist es wichtig, daß der Magnet 8 in jeder Schaltstellung eine eindeutige Position einnimmt, die sich von allen anderen Positionen genug unterscheidet, damit diese sicher vom Magnetsensor 9 detektiert werden kann.

Bei einer Schwenkbewegung des Schalthebels 1 um die zweite Achse 5 ist der erreichbare Hub des Schlittens 10 bei einer direkten Mitnahme durch den Schalthebel 1, wie er in den Figuren 1 bis 3 dargestellt ist, unmittelbar von der Schaltbewegung des Schalthebels 1 abhängig. Eine Verschwenkung des Schalthebels 1 um einen kleinen Winkel führt somit zu einem geringen Hub des Schlittens 10 und damit auch des Magneten 8.

Ist die Schwenkbewegung des Schalthebels 1 um die zweite Achse 5 zu klein, wird kein ausreichender Hub des Magneten 8 erreicht, um dessen Positionen sicher zu erkennen und von anderen Positionen zu unterscheiden.

Mithilfe des Umlenkhebels 24, können gemäß des zweiten Ausführungsbeispiels kleine Schwenkbewegungen des Schalthebels 1 entsprechend übersetzt und damit vergrößert werden. Kleine Schwenkbewegungen des Schalthebels 1 können so einen relativ großen Hub des Schlittens 10 und des daran angeordneten Magneten 8 bewirken.

Damit ist die Linearbewegung des Schlittens 10 nicht mehr allein von der Schwenkbewegung des Schalthebels 1 abhängig, sondern wird auch durch das durch den Umlenkhebel 24 verwirklichte Übersetzungsverhältnis mitbestimmt.

### Bezugszeichen

- 1: Schalthebel
- 2: Lagerstellen
- 3: Schaltstück
- 4: erste Achse
- 5: zweite Achse
- 6: Rasthülse
- 7: Rastkurve
- 8: Magnet
- 9: Magnetsensor
- 10: Schlitten
- 11: Ausnehmung
- 12: Auslösesystem
- 13: Durchbruch
- 14: Lagerstellen
- 15: Endstück
- 16: Griffstück
- 17: Druckfeder
- 18: Magnethalter
- 19: Leiterplatte
- 20: Seitenteile
- 21: Gleitnuten
- 22: Querträger
- 23: Mitnahmeelement
- 24: Umlenkhebel
- 25: erste Langlochführungen
- 26: zweite Langlochführungen
- 27: Lagerstifte
- 28: Verbindungssteg
- 35: erste Führungsstifte
- 36: zweite Führungsstifte
- 37: Lagerausnehmungen

## Patentansprüche

1. Lenkstockschalter für ein Kraftfahrzeug,
mit einem in zwei zueinander senkrechten Richtungen verschwenkbaren Schalthebel (1),
mit einem um eine erste Achse (4) verschwenkbar gelagerten Schaltstück (3),
wobei der Schalthebel (1) in dem Schaltstück (3) um eine zur ersten Achse (4) senkrecht angeordnete zweiten Achse (5) verschwenkbar gelagert ist,
wobei der Schalthebel (1) an einem Endstück (15) eine federbelastete Rasthülse (6) trägt, die in einer Rastkurve (7) an verschiedenen Positionen einrastbar ist,
und mit mindestens einem Magneten (8) und mindestens einem Magnetsensor (9), die durch Bewegungen des Schalthebels (1) relativ zueinander positionierbar sind,
**dadurch gekennzeichnet,**
**dass** der mindestens eine Magnet (8) fest mit einem Schlitten (10) verbunden ist, der parallel zur ersten Achse (4) linear verschiebbar am Schaltstück (3) gelagert ist und der den Bewegungen des Schalthebels (1) um die zweite Achse (5) folgt, und
**dass** der mindestens eine Magnet (8) bei Schwenkbewegungen des Schaltstücks (3) um dessen erste Achse (4) mit verschwenkt wird.

2. Lenkstockschalter nach Anspruch 1, **dadurch gekennzeichnet, dass** der Schlitten (10) rahmenartig ausgebildet ist und eine Ausnehmung (11) aufweist, durch die die Rasthülse (6) hindurchgeführt ist.

3. Lenkstockschalter nach Anspruch 2, **dadurch gekennzeichnet, dass** mindestens ein Teil eines Auslösesystems (12), welches zum Zurückführen des Schalthebels (1) aus einer betätigten Schaltstellung geeignet ist, durch die Ausnehmung (11) hindurchgeführt ist.

4. Lenkstockschalter nach Anspruch 1, **dadurch gekennzeichnet, dass** der Schlitten (10) mittels eines am Schaltstück (3) drehbar gelagerten Umlenkhebels (24) mit dem Schalthebel (1) gekoppelt ist.

## Claims

1. Steering column switch for a motor vehicle,
with a switch lever (1) pivotable in two mutually perpendicular directions,
with a switching piece (3) pivotably mounted about a first axis (4),
wherein the switch lever (1) is pivotably mounted in the switching piece (3) about a second axis (5) arranged perpendicular to the first axis (4),
wherein the switch lever (1) carries on an end piece (15) a spring-loaded detent sleeve (6) which can be engaged at various positions in a detent cam (7),
and with at least one magnet (8) and at least one magnetic sensor (9), which can be positioned relative to one another by movements of the switch lever (1),
**characterized in that**
the at least one magnet (8) is firmly connected to a slide (10) which is mounted on the switching piece (3) so as to be linearly displaceable parallel to the first axis (4) and which follows the movements of the switch lever (1) about the second axis (5), and
that the at least one magnet (8) is also pivoted about the first axis (4) of the switching piece (3) during pivoting movements of the latter.

2. Steering column switch according to claim 1, **characterized in that** the slide (10) is of frame-like design and has a recess (11) through which the detent sleeve (6) is guided.

3. Steering column switch according to claim 2, **characterized in that** at least one part of a release system (12), which is suitable for returning the switch lever (1) from an actuated shift position, is guided through the recess (11).

4. Steering column switch according to claim 1, **characterized in that** the slide (10) is coupled to the switch lever (1) by means of a deflection lever (24) rotatably mounted on the switching piece (3).

## Revendications

1. Commutateur de colonne de direction pour véhicule automobile,
avec un levier de commande (1) pouvant pivoter dans deux directions perpendiculaires entre elles,
avec une pièce de commutation (3) montée pivotante autour d'un premier axe (4),
le levier de commande (1) étant monté dans la pièce de commutation (3) de manière à pouvoir pivoter autour d'un deuxième axe (5) perpendiculaire au premier axe (4),
le levier de commande (1) portant sur une pièce d'extrémité (15) une douille d'encliquetage (6) sollicitée par ressort, qui peut être encliquetée dans différentes positions dans une courbe d'encliquetage (7),
et avec au moins un aimant (8) et au moins un capteur magnétique (9), qui peuvent être positionnés l'un par rapport à l'autre par des mouvements du levier de commande (1),
**caractérisé en ce que**
le au moins un aimant (8) est relié de manière fixe à un chariot (10) qui est monté sur la pièce de commutation (3) de manière à pouvoir être déplacé linéairement parallèlement au premier axe (4) et qui suit les mouvements du levier de commande (1) autour du deuxième axe (5), et
**en ce que** l'au moins un aimant (8) est également pivoté autour du premier axe (4) de la pièce de commutation (3) lors de mouvements de pivotement de celle-ci.

2. Commutateur de colonne de direction selon la revendication 1, **caractérisé en ce que** le chariot (10) est réalisé en forme de cadre et présente un évidement (11) à travers lequel passe la douille d'arrêt (6).

3. Commutateur de colonne de direction selon la revendication 2, **caractérisé en ce qu'**au moins une partie d'un système de déclenchement (12), qui est approprié pour ramener le levier de commande (1) d'une position de changement de vitesse actionnée, est passée à travers l'évidement (11).

4. Commutateur de colonne de direction selon la revendication 1, **caractérisé en ce que** le chariot (10) est couplé au levier de commande (1) au moyen d'un levier de renvoi (24) logé de manière rotative sur la pièce de commutation (3).
